Europäisches Patentamt

European Patent Office

Office européen des brevets

(11) Veröffentlichungsnummer: **0 171 125**
**B1**

(12) **EUROPÄISCHE PATENTSCHRIFT**

(45) Veröffentlichungstag der Patentschrift: **14.11.90**

(51) Int. Cl.⁵: **H 03 K 5/02, H 04 L 12/28**

(21) Anmeldenummer: **85201273.1**

(22) Anmeldetag: **06.08.85**

(54) Schaltungsanordnung zum Übertragen von binären Signalen.

(30) Priorität: **06.08.84 DE 3429982**

(43) Veröffentlichungstag der Anmeldung:
**12.02.86 Patentblatt 86/07**

(45) Bekanntmachung des Hinweises auf die Patenterteilung:
**14.11.90 Patentblatt 90/46**

(84) Benannte Vertragsstaaten:
**DE FR GB IT**

(56) Entgegenhaltungen:
**EP-A-0 094 238**
**US-A-4 289 977**

**ELECTRONIC DESIGN, Band 24, Nr. 24, 22. November 1976, Seite 168, Rochelle Park, US; L. ACKER: "Inverter circuit handles bidirectional signal flow without latching up"**

(73) Patentinhaber: **Philips Patentverwaltung GmbH Wendenstrasse 35 Postfach 10 51 49 D-2000 Hamburg 1 (DE)**
(84) **DE**

(73) Patentinhaber: **N.V. Philips' Gloeilampenfabrieken Groenewoudseweg 1 NL-5621 BA Eindhoven (NL)**
(84) **FR GB IT**

(72) Erfinder: **Schillhof, Udo Steindamm 26e D-2061 Itzstedt (DE)**
Erfinder: **Hesse, Winfried Bäckerstrasse 2 D-2000 Schenefeld (DE)**

(74) Vertreter: **Poddig, Dieter, Dipl.-Ing. et al Philips Patentverwaltung GmbH Wendenstrasse 35 Postfach 10 51 49 D-2000 Hamburg 1 (DE)**

**Beschreibung**

Die Erfindung betrifft eine Schaltungsanordnung zum Übertragen von binären Signalen in beiden Richtungen, die zwischen einer Leitung, die über mindestens einen ersten Widerstand mit einem Pol einer Spannungsquelle verbunden ist, und einer auf mindestens einen nur bei dem einen binären Signalwert niederohmigen Datensender sowie mindestens einen Datenempfänger mit relativ hohem Eingangswiderstand führende Busleitung geschaltet ist.

Eine derartige Schaltunganordnung dient insbesondere dazu, ein Teilsystem aus mehreren einzelnen Anordnungen, die räumlich nahe beieinander angeordnet und über eine kurze Busleitung miteinander verbunden sind, über die Leitung mit einem entsprechenden, jedoch räumlich weiter davon entfernt angeordneten Teilsystem zu verbinden, das ebenfalls eine Busleitung aufweisen kann, wenn dieses Teilsystem nicht gerade nur einen einzigen Datensender und einen einzigen Datenempfänger hat. Jede Busleitung ist ebenfalls über einen Widerstand mit dem einen Pol der Spannungsquelle verbunden, und ein Datensender besteht üblicherweise aus einem zwischen der Busleitung und dem anderen Pol der Spannungsquelle angeordneten Transistor, der bei dem einen binären Wert der zu übertragenden Daten die Busleitung mit dem anderen pol der Spannungsquelle, das ist üblicherweise das 0 Volt-Potential des gesamten Systems, verbindet. Anschließend wird der Transistor im Datensender gesperrt, und das Potential auf der Busleitung geht wieder auf den Spannungwert des einen Pols der Spannungsquelle, üblicherweise + 5 Volt.

Bei der Übertragung von Daten mit hoher Frequenz entsteht durch die Kapazität der Busleitung gegenüber der Umgebung die Schwierigkeit, daß für den Signalwechsel auf 0 Volt die Kapazität der Busleitung durch den leitenden Transistor im Datensender relativ schnell entladen werden kann, daß jedoch beim Sperren des Transistors das Signal auf der Busleitung entsprechend der Zeitkonstanten aus der durch die Busleitung dargestellten Kapazität und dem mit +5 Volt verbundenen Widerstand ansteigt. Der Wert dieses Widerstandes ist durch die Strombelastbarkeit der Transistoren in den Datensendern begrenzt, da diese allgemein in integrierten Schaltungen angeordnet sind, so daß nur eine begrenzte Kristallfläche zur Verfügung steht und auch die Verlustleistung nicht zu hoch werden darf. Damit ist für eine vorgegebene Übertragungsgeschwindigkeit bzw. Datenfolgefrequenz die Länge der Busleitung begrenzt. Eine Verbesserung kann dadurch erreicht werden, daß der Widerstand, der die Busleitung mit dem einen Pol der Spannungsquelle verbindet, durch einen Stromgenerator ersetzt wird. Diese Möglichkeit bringt jedoch nur eine geringe Verbesserung und erfordert im Verhältnis dazu einen hohen Aufwand.

Um binäre Daten mit hoher Geschwindigkeit über eine bidirektionale Verbindung zu übertragen, wird daher die eingangs genannte Schaltungsanordnung verwendet, die beispielsweise als integrierte Schaltungsanordnung unter der Bezeichnung SN 74 LS 243 vertrieben wird. Eine derartige integrierte Schaltung enthält für eine Busleitung einen Ausgangsverstärker, der das auf der Busleitung vorhandene Signal niederohmig einer längeren Verbindungsleitung zuführt, sowie einen Empfangsverstärker, der das von der Verbindungsleitung kommende Signal der Busleitung zuführt. Aus Gründen der Stabilität und des Stromverbrauches wird über Steuersignale nur einer der beiden Verstärker eingeschaltet, wobei durch entsprechende Steuersignale unbedingt sichergestellt sein muß, daß niemals beide Verstärker gleichzeitig eingeschaltet sind. Um solche Sende-Empfängerschaltungen leichter betreiben zu können, ist bei integrierten Schaltungen mit beispielsweise der Typenbezeichnung SN 74 LS 245 durch interne Verknüpfungsglieder festgelegt, daß nur jeweils eine Signalrichtung freigegeben ist. In jedem Falle müssen jedoch die entsprechenden Steuersignale vorhanden sein, um die Signalrichtung umzuschalten. Eine Schaltungsanordnung der eingangs genannten Art, die ohne Steuersignale bzw. mit bestimmten konstanten Steuersignalen die Übertragungsrichtung automatisch umschaltet, ist beispielsweise als integrierte Schaltung unter der Bezeichnung 8X41 bekannt. Diese bekannte Schaltungsanordnung ist jedoch sehr aufwendig, und sie ermöglicht eine Umschaltung der Übertragungsrichtung nur dann, wenn sowohl die Busleitung als auch die Verbindungsleitung ein hohes Potential führen.

Aufgabe der Erfindung ist es, eine Schaltungsanordnung der eingangs genannten Art anzugeben, die ohne Verwendung von zusätzlichen Steuersignalen und ohne Stabilitätsprobleme die Übertragung von Daten in beiden Richtungen mit einfachen Mitteln ermöglicht, und zwar bei beiden Werten der übertragenen Signale.

Diese Aufgabe wird erfindungsgemäß dadurch gelöst, daß ein Transistor vorgesehen ist, dessen einer Hauptstromanschluß mit der Leitung und über einen zweiten Widerstand mit dem Steueranschluß des Transistors verbunden ist, dessen Steueranschluß mit der Busleitung verbunden ist und dessen anderer Hauptstromanschluß mit dem anderen Pol der Spannungsquelle verbunden ist.

Die erfindungsgemäße Schaltung ist in der Lage, ohne Verwendung von Steuersignalen die Übertragung von Daten in beiden Richtungen zu ermöglichen, so daß insbesondere in dem Fall, wenn die Busleitung durch einen Datensender auf ein niedriges Potential gebracht war und dieses Potential auf die Leitung übertragen wurde, ein von einer anderen Stelle auf die Leitung aufgebrachtes niedriges Potential auf die Busleitung übertragen wird, wenn der Transistor im Datensender wieder gesperrt wird. Die erfindungsgemäße Schaltungsanordnung stellt also eine problemlose Busleitungsverlängerung dar, die nur sehr wenig Aufwand erfordert.

Eine günstige Ausgestaltung ergibt sich, wenn der Transistor ein bipolarer PNP-Transistor ist und der erste Widerstand unmittelbar bei dem Transistor angeordnet ist. Ein bipolarer Transistor ist auch für höhere Ströme relativ preiswert und ergibt praktisch keine Schwierigkeiten durch Potentialverschiebungen zwischen Leitung und Busleitung. Eine andere günstige Möglichkeit besteht darin, daß der Transistor ein P-Kanal Feldeffekttransistor ist und der erste Widerstand unmittelbar beim Transistor angeordnet ist.

Die Bemessung des ersten Widerstandes kann sich nach verschiedenen Gesichtspunkten richten, beispielsweise nach der maximalen Belastbarkeit des Transistors. Zweckmäßig ist es, daß der Wert des ersten Widerstandes dem Wellenwiderstand der Leitung entspricht und der Wert des zweiten Widerstandes mindestens das Zehnfache davon beträgt. Dadurch werden Reflexionen auf der Leitung vermieden, die insbesondere bei größerer Leitungslänge störend sein können. Jeder Transistor muß dann allerdings so viel Strom liefern können, wie die an allen Einspeisestellen der Leitung angeschlossenen ersten Widerstände anderer entsprechender Schaltungsanordnungen benötigen. Der zweite Widerstand, der für die Busleitung den mit dem einen Pol der Spannungsquelle verbundenen Widerstand darstellt, kann so groß gewählt sein, wie es die gewünschte Datenübertragungsgeschwindigkeit und die vorhandene Kapazität der Busleitung ermöglichen.

Eine andere Möglichkeit besteht darin, daß der Wert des ersten Widerstandes entsprechend der Ausgangsbelastbarkeit der Busleitung und der Stromverstärkung des Transistors bemessen ist. Da die an der Busleitung angeschlossenen Datensender häufig nur begrenzte Ströme liefern können, während Transistoren mit hoher Schaltgeschwindigkeit keine großen Stomverstärkungen aufweisen, kann dadurch der maximale Wert des ersten Widerstandes begrenzt sein.

Ausführungsbeispiele der Erfindung werden nachstehend anhand der Zeichnung näher erläutert:

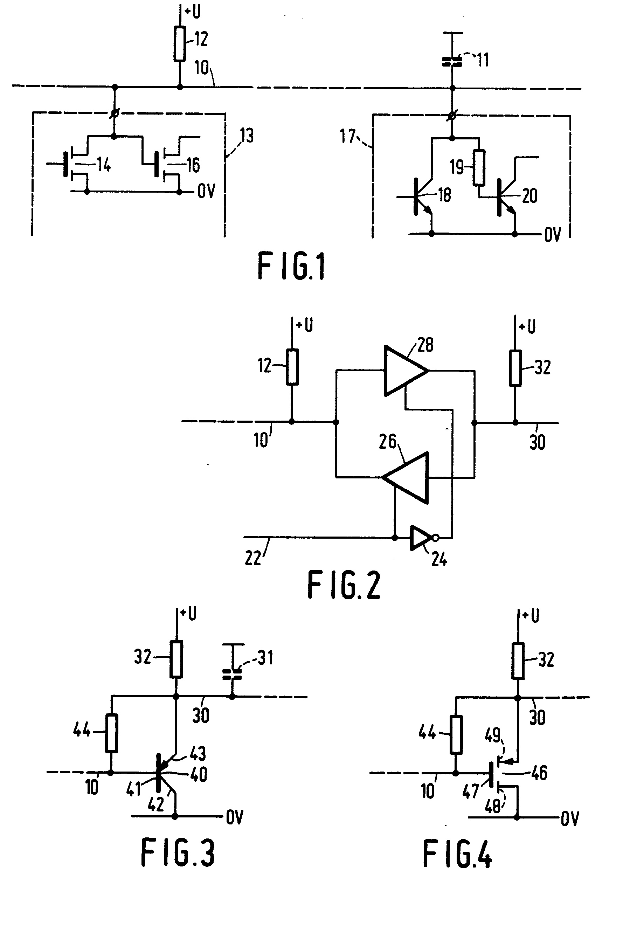

Es zeigen Fig. 1 eine übliche Busleitung mit mehreren Datensendern und — empfängern,

Fig. 2 eine bekannte Schaltungsanordnung zur Verlängerung eines Datenbusses mit umschaltbarer Übertragungsrichtung,

Fig. 3 eine erfindungsgemäße Schaltungsanordnung mit einem bipolaren Transistor,

Fig. 4 eine erfindungsgemäße Schaltungsanordnung mit einem Feldeffekt-Transistor.

In Fig. 1 ist eine Busleitung 10 über einen Widerstand 12 mit dem einen Pol +U einer nicht dargestellten Spannungsquelle verbunden. Ferner führt die Busleitung 10 über einen Anschlußpunkt auf eine integrierte Schaltung 13, von der nur der Transistor 14 des Datensenders und der Transistor 16 des Datenempfängers dargestellt ist. Dabei handelt es sich um Feldeffekt-Transistoren, deren Source mit dem Bezugspotential 0V verbunden ist, während die Busleitung 10 auf die Drain des Sendetransistors 14 und auf das Gate des Transistors 16 führt. Ferner führt die Busleitung 10 auf eine weitere integrierte Schaltung 17, die in bipolarer Technik ausgeführt ist und von der nur der Transistor 18 des Datensenders und der Transistor 20 des Datenempfängers dargestellt ist. Die Emitter beider Transistoren sind wieder mit dem Bezugspotential 0V verbunden, während die Busleitung 10 auf den Kollektor des Transistors 18 und über einen Widerstand 19 auf die Basis des Transistors 20 führt.

Wenn von der integrierten Schaltung 13 zur Schaltung 17 Daten übertragen werden sollen, wird das Gate des Transistors 14 angesteuert, so daß dieser durchschaltet und die Busleitung 10 praktisch auf das Potential 0V bringt. Es wird angenommen, daß währenddessen der Transistor 18 gesperrt ist, so daß kein Strom durch ihn fließt. Das niedrige Potential gelangt an die Basis des Transistors 20 und sperrt diesen, so daß dessen Kollektor, der mit signalverarbeitenden Teilen der integrierten Schaltung verbunden ist, stromlos wird. Wenn anschließend der Transistor 14 wieder gesperrt wird, geht das Potential auf der Busleitung 10 wieder auf die Spannung +U, entsprechend der Zeitkonstanten aus dem Wert des Widerstandes 12 und der Kapazität der Busleitung gegenüber der Umgebung, die hier symbolisch mit dem Kondensator 11 dargestellt ist. Bei kurzen Busleitungen 10 ist der Wert dieser Kapazität 11 klein, so daß die Anstiegsflanke des Signals auf der Busleitung 10 relativ kurz ist. Wenn jedoch aus räumlichen Gründen eine lange Busleitung 10 erforderlich ist, wächst der Wert der Kapazität 11, und die ansteigende Flanke des Signals auf der Busleitung 10 wird sehr lang und begrenzt die maximale Datenübertragungsgeschwindigkeit über die Busleitung 10. Eine Verkleinerung des Werts des Widerstandes 12 ist häufig nicht ohne weiteres möglich, da die Transistoren 14 und 18 und gegebenenfalls weiterer an die Busleitung 10 angeschlossener integrierter Schaltungen nur relativ geringe Ströme treiben können.

Häufig bilden eine Anzahl integrierter Schaltungen ein Teilsystem, dessen einzelne Elemente räumlich eng benachbart und über eine relativ kurze Busleitung 10 miteinander verbunden sind. Dabei können auch mehrere derartiger Busleitungen 10 für verschiedene Daten- und Steuersignale verwendet werden. Ein derartiges Teilsystem muß dann mit einem räumlich entfernt angeordneten anderen Teilsystem verbunden werden. Für diesen Zweck sind Bustreiber und -empfänger bekannt, beispielsweise mit der Bezeichnung SN 74 LS 245, die für jede Busleitung 10 zwei Verstärker 26 und 28 aufweisen, wobei die Busleitung 10 mit dem Eingang des Verstärkers 28 und dem Ausgang des Verstärkers 26 verbunden ist, wie in Fig. 2 dargestellt ist. Diese Verstärker sind schaltbar, d.h. sie können die Signalverbindung vom Eingang zum Ausgang unterbrechen, und zwar durch ein über die Leitung 22 zugeführtes Steuersignal. Bei dem einen Wert des Steuersignals auf der Leitung 22 ist beispielsweise der Verstärker 26 wirksam und über den Inverter 24 der Verstärker 28 gesperrt, so daß ein niedriges Potential von der Leitung 30, die mit dem Eingang des Verstärkers 26 und dem Ausgang des Verstärkers 28 verbunden ist, zur Busleitung 10 durchgeschaltet wird. Bei dem anderen Signalwert auf der Leitung 22 ist der Verstärker 26 gesperrt und der Verstärker 28 wirksam, so daß ein auf der Busleitung 10 vorhandener Signalwert auf die Leitung 30 durchgeschaltet wird. Die Verstärker 26 und 28 enthalten beispielsweise am Ausgang Anordnungen wie die Transistoren 14 bzw. 18 in Fig. 1, und daher ist außer der Busleitung 10 auch die Leitung 30, die zu einem entfernten Teilsystem führt, über einen Widerstand 32 mit dem einen Pol +U einer Spannungsquelle verbunden. Mit dieser bekannten Schaltung ist es jedoch nicht möglich, einen automatischen Übergang von der Sendefunktion zur Empfangsfunktion durchzuführen, beispielsweise indem zunächst ein niedriges Signal auf der Busleitung 10 erzeugt und dieses auf die Leitung 30 und weiter auf das entfernte System übertragen wird und dieses dann unmittelbar mit einemniedrigen Potential anwortet, so daß die Busleitung 10 niedrig bleibt, obwohl der daran angeschlossene Datensender bereits wieder hochohmig geworden ist, da dann das Signal auf der Leitung 22 im richtigen Augenblick umgeschaltet werden müßte, der jedoch in dem Teilsystem an der Busleitung 10 nicht ohne weiteres bekannt ist.

Bei der Schaltungsanordnung nach Fig. 3 führt nun die Busleitung 10 auf die Basis 41 eines PNP-Transistors 40, dessen Kollektor mit dem Bezugspotential 0V verbunden ist. Die Busleitung 10 ist ferner über einen Widerstand 44 mit dem Emitter 43 des Transistors 40 verbunden. Dieser Widerstand 44 ersetzt den direkt mit dem einen Pol +U der Spannungsquelle verbundenen Widerstand 12 in Fig. 1 bzw. Fig. 2. Der Emitter 43 des Transistors 40 ist ferner mit der Leitung 30 verbunden, die über den Widerstand 32 mit dem einen Pol +U der Spannungsquelle verbunden ist.

Wenn ein an die Busleitung 10 angeschlossener Transistor in einem Datensender leitend geschaltet wird, geht das Potential auf der Busleitung 10 nahezu auf 0V. Damit geht auch das Potential auf der Leitung 30 herunter, und zwar auf einen Wert $U_{BE}$, d.h. um die Basis-Emitter-Spannung des Transistors 40 positiver als die Bezugsspannung 0V.

Dabei fließt der Strom im Transistor des Datensenders an der Busleitung 10 zum Teil über den Widerstand 44 und im übrigen über die Basis 41 des Transistors 40, so daß in dessen Emitter 43 ein wesentlich höherer Strom fließen kann als über die Busleitung 10, so daß der Widerstand 32 einen relativ niedrigen Wert erhalten kann. Wenn nun der Transistor im Datensender an der Busleitung 10 wieder gesperrt wird, entlädt sich die relativ kleine Kapazität der Busleitung 10 über den Widerstand 44 auf, der damit relativ groß sein kann. Die Kapazität 31 der Leitung 10 entlädt sich dagegen über den Widerstand 32 auf, der einen relativ kleinen Wert hat, so daß auf der Leitung 30 ebenfalls eine steile ansteigende Flanke erreicht wird. Der Wert des Widerstandes 32 kann nun nach der Stromverstärkung des Transistors 40 und dem maximal zulässigen Strom auf der Busleitung 10 gewählt werden, wobei berücksichtigt werden muß, daß an der Leitung 10 mehrere der in Fig. 3 dargestellten Anordnungen angeschlossen sein können, deren Widerstände 32 dann parallel geschaltet sind. Wenn jedoch die Leitung 30 einen definierten Wellenwiderstand hat und dieser größer als der minimal zulässige Wert des Widerstandes 32 ist, der sich aufgrund der Stromverstärkung des Transistors 40 und des zulässigen Stromes auf der Busleitung 10 ergibt, kann der Wert des Widerstandes 32 auch gleich dem Wellenwiderstand gewählt werden. Wenn die Leitung 30 jedoch nur kurz ist und damit eine kleine kapazitive Belastung darstellt, kann der Wert des Widerstandes 32 auch größer gewählt werden, um den Stromverbrauch des gesamten Systems zu verringern. Der Wert des Widerstandes 44 sollte klein genug sein, um eine rasche Aufladung der Busleitung 10 zu ermöglichen, jedoch sollte er nicht zu klein sein, da sonst die wirksame Stromverstärkung des Transistors 40 zu sehr verringert wird.

Wenn in der Schaltung nach Fig. 3 an der Busleitung 10 kein leitender Transistor eines Datensenders vorhanden ist, jedoch über die Leitung 30 von einer anderen, insbesondere einer der Fig. 3 entsprechenden Anordnung ein niedriges Potential zugeführt wird, führt dieses über den Widerstand 44 und die Busleitung 10 auf die Eingänge der daran angeschlossenen Datenempfänger. Da sowohl die gesperrten Transistoren der Datensender als auch die Eingänge der Datenempfänger relativ hochohmig sind, muß über den Widerstand 44 lediglich die Kapazität der Busleitung 10 auf das niedrige Potential der Leitung 30 umgeladen werden, so daß eine schnelle Übertragung einer negativen Signalflanke auf der Leitung 30 auf die Busleitung 10 stattfindet. Auf diese Weise ist die Anordnung nach Fig. 3 für beide Signalrichtungen durchlässig, ohne daß eine Umschaltung der Signalrichtung erforderlich ist.

In Fig. 4 ist der Transistor als P-Kanal Feldeffekt-Transistor 46 ausgeführt. Dessen Drain 48 ist mit der Bezugsspannung 0V verbunden, die Source 49 ist mit der Leitung 40, dem Widerstand 32 und dem Widerstand 44 verbunden, und das Gete 47 ist mit dem anderen Ende des Widerstandes 44 und der Busleitung 10 verbunden. Die Funktion der Schaltung ist völlig entsprechend der Schaltung nach Fig. 3, wobei lediglich die Schwellspannung des Transistors 46 geeignet gewählt werden muß, damit die Spannungsdifferenz zwischen dem Potential auf der Busleitung 10 und der Leitung 30 für eine ausreichend sichere Signalübertragung geeignet ist.

## Patentansprüche

1. Schaltungsanordnung zum Übertragen von binären Signalen in beiden Richtungen, die zwischen einer Leitung, die über mindestens einen ersten Widerstand mit einem Pol einer Spannungsquelle verbunden ist, und einer auf mindestens einen nur bei dem einen binären Signalwert niederohmigen Datensender sowie mindestens einen Datenempfänger mit relativ hohem Eingangswiderstand führende Busleitung geschaltet ist,

dadurch gekennzeichnet,

daß ein Transistor (40; 46) vorgesehen ist, dessen einer Hauptstromanschluß (43; 49) mit der Leitung (30) und über einen zweiten Widerstand (44) mit dem Steueranschluß (41; 47) des Transistors (40; 46) verbunden ist, dessen Steueranschluß (41; 47) mit der Busleitung (10) verbunden ist und dessen anderer Hauptstromanschluß (42; 48) mit dem anderen Pol (0V) der Spannungsquelle verbunden ist.

2. Schaltungsanordnung nach Anspruch 1, dadurch gekennzeichnet,

daß der Transistor ein bipolarer PNP-Transistor (40) ist und der erste Widerstand (32) unmittelbar bei dem Transistor (40) angeordnet ist.

3. Schaltungsanordnung nach Anspruch 1, dadurch gekennzeichnet, daß der Transistor ein P-Kanal Feldeffekttransistor ist und der erste Widerstand (32) unmittelbar beim Transistor (46) angeordnet ist.

4. Schaltungsanordnung nach Anspruch 1, 2 oder 3, dadurch gekennzeichnet,

daß der Wert des ersten Widerstandes (32) dem Wellenwiderstand der Leitung (30) entspricht und der Wert des zweiten Widerstandes (44) mindestens das Zehnfache davon beträgt.

5. Schaltungsanordnung nach Anspruch 2, dadurch gekennzeichnet,

daß der Wert des ersten Widerstandes (32) entsprechend der Ausgangsbelastbarkeit der Busleitung (10) und der Stromverstärkung des Transistors (40) bemessen ist.

6. Bussystem, dadurch gekennzeichnet,

daß eine Schaltungsanordnung nach einem der vorherigen Ansprüche darin enthalten ist.

**Revendications**

1. Montage de circuit pour la transmission bidirectionnelle de signaux binaires qui est monté entre une ligne connectée par l'intermédiaire d'au moins une première résistance à un pôle d'une source de tension et une ligne de bus conduisant à au moins un émetteur de données qui ne présente une faible impédance que pour l'une des valeurs de signaux binaires et à au moins un récepteur de données à résistance d'entrée relativement élevée, caractérisé en ce qu'il est prévu un transistor (4); 46) dont l'une des connexions de courant principal (43; 49) est connectée à la ligne (30) et, par l'intermédiaire d'une seconde résistance (44), à la connexion de commande (41; 47) du transistor (40; 46), la connexion de commande (41; 47) de ce transistor étant connectée à la ligne de bus (10) et l'autre connexion de courant principal (42; 48) de ce transistor étant connectée à l'autre pôle (0 volt) de la source de tension.

2. Montage de circuit suivant la revendication 1, caractérisé en ce que le transistor est un transistor PNP bipolaire (40) et la première résistance (32) est disposée à proximité immédiate du transistor (40).

3. Montage de circuit suivant la revendication 1, caractérisé en ce que le transistor est un transistor à effet de champ à canal P et la première résistance (32) est disposée à proximité immédiate du transistor (46).

4. Montage de circuit suivant la revendication 1, 2 ou 3, caractérisé en ce que la valeur de la première résistance (32) correspond à l'impédance caractéristique de la ligne (30) et la valeur de la deuxième résistance (44) en est au moins le décuple.

5. Montage de circuit suivant la revendication 2, caractérisé en ce que la valeur de la première résistance (32) est choisie en fonction de la capacité de charge de sortie de la ligne de bus (10) et de l'amplification de courant du transistor (40).

6. Système de bus, caractérisé en ce qu'il comporte un montage de circuit suivant l'une quelconque des revendications précédentes.

**Claims**

1. A circuit arrangement for the bidirectional transmission of binary signals, which circuit arrangement is connected between a line, connected to one pole of a voltage source via at least a first resistor, and a bus which is connected to at least one data transmitter which is low-ohmic only for one binary signal value as well as to at least one data receiver which has a comparatively high input resistance, characterized in that there is provided a transistor (40; 46), one main terminal (43; 49) of which is connected to the line (30) and, via a second resistor (44), to the control terminal (41; 47) of the transistor (40; 46), its control terminal (41; 47) being connected to the bus (10) whilst its other main terminal (42; 48) is connected to the other pole (0 V) of the voltage source.

2. A circuit arrangement as claimed in Claim 1, characterized in that the transistor is a bipolar PNP transistor (40), the first resistor (32) being arranged in the direct vicinity of the transistor (40).

3. A circuit arrangement as claimed in Claim 1, characterized in that the transistor is a P-channel field effect transistor, the first resistor (32) being arranged in the direct vicinity of the transistor (46).

4. A circuit arrangement as claimed in Claim 1, 2 or 3, characterized in that the value of the first resistor (32) corresponds to the characteristic impedance of the line (30), the value of the second resistor (44) amounting to at least ten times said impedance.

5. A circuit arrangement as claimed in Claim 2, characterized in that the value of the first resistor (32) is chosen so as to correspond to the output loadability of the bus (10) and the current amplification of the transistor (40).

6. A bus system, characterized in that it includes a circuit arrangement as claimed in any one of the preceding Claims.

FIG.1

FIG.2

FIG.3

FIG.4